# EUROPEAN PATENT APPLICATION

(11) **EP 4 696 753 A1**
(43) Date of publication of application: **18.02.2026**
(21) Application number: 24800185.1
(22) Date of filing: 19.04.2024
(51) Int. Cl.: C09J 7/10, C09J 7/40, H04M 1/02

(54) **ADHESIVE MEMBER AND ELECTRONIC DEVICE COMPRISING SAME**

(30) Priority: 04.05.2023 KR 20230058778; 26.05.2023 KR 20230068316
(71) Applicant: Samsung Electronics Co., Ltd., Suwon-si, Gyeonggi-do 16677 (KR)
(72) Inventor: YU, Jaewon, Suwon-si Gyeonggi-do 16677 (KR); KIM, Inhwan, Suwon-si Gyeonggi-do 16677 (KR); YANG, Soohyeon, Suwon-si Gyeonggi-do 16677 (KR)
(74) Representative: Gulde & Partner
(86) International application number: PCT/KR2024/005351
(87) International publication number: WO 2024/228501

(57) **Abstract**

The present disclosure relates to an electronic device. The electronic device according to one embodiment of the present disclosure comprises: a housing comprising a support member extending in a first direction; a display comprising a film facing the support member; and an adhesive member, which is arranged between the support member and the film, comprises a plurality of slits arranged in the first direction, and has a width in a second direction crossing the first direction, wherein at least any one from among the plurality of slits comprises: a first slit portion which extends in the first direction, and which faces, in the width direction of the adhesive member, a part of another slit adjacent to the first slit portion from among the plurality of slits; a second slit portion which is spaced apart from the first slit portion, and which faces, in the width direction of the adhesive member, a part of another slit adjacent to the second slit portion from among the plurality of slits; and a third slit portion which connects the first slit portion and the second slit portion and which extends to be tilted in the first direction.

## Description

### [Technical Field]

Various embodiments of the disclosure relate to an electronic device, e.g., an adhesive member and an electronic device including the same.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function, such as for mobile banking, and a scheduling or e-wallet function. These electronic devices have been downsized to be conveniently carried by users.

### [Detailed Description of the Invention]

### [Technical Solution]

An electronic device according to an embodiment of the disclosure comprises a housing comprising a supporting member extending in a first direction, a display comprising a film facing the supporting member, and an adhesive member disposed between the supporting member and the film, comprising a plurality of slits disposed in the first direction, and having a width in a second direction crossing the first direction. At least one of the plurality of slits comprises a first slit portion extending along the first direction, and facing, in a width direction of the adhesive member, a portion of another one adjacent to the first slit portion among the plurality of slits, a second slit portion spaced apart from the first slit portion, and facing, in a width direction of the adhesive member, a portion of another one adjacent to the second slit portion among the plurality of slits, and a third slit portion connecting the first slit portion and the second slit portion and obliquely extending with respect to the first direction.

An electronic device according to an embodiment of the disclosure comprises a housing comprising a supporting member extending in a first direction, a display comprising a film facing the supporting member, and an adhesive member disposed between the supporting member and the film, comprising a plurality of slits arranged in the first direction, and having a width in a second direction crossing the first direction. At all portions of the adhesive member extending along the first direction, at least a portion of the plurality of slits is positioned in the width of the adhesive member.

### [Brief Description of Drawings]

FIG. 1 is a block diagram illustrating an electronic device in a network environment according to an embodiment;
FIG. 2 is a front perspective view illustrating an electronic device according to an embodiment of the disclosure;
FIG. 3 is a rear perspective view illustrating an electronic device according to an embodiment of the disclosure;
FIG. 4 is a front exploded perspective view illustrating an electronic device according to an embodiment of the disclosure;
FIG. 5 is a rear exploded perspective view illustrating an electronic device according to an embodiment of the disclosure;
FIG. 6 is a portion of an exploded view illustrating an electronic device according to an embodiment of the disclosure;
FIG. 7 is a portion of an exploded view illustrating an electronic device according to an embodiment of the disclosure;
FIG. 8 illustrates an adhesive member according to an embodiment of the disclosure;
FIG. 9 illustrates a release sheet according to an embodiment of the disclosure;
FIG. 10A illustrates a display before attaching an adhesive member according to an embodiment of the disclosure;
FIG. 10B illustrates a display after attaching an adhesive member and a release sheet according to an embodiment of the disclosure;
FIG. 10C illustrates a state in which a release sheet has been removed from an adhesive member according to an embodiment of the disclosure;
FIG. 11 illustrates an adhesive member according to an embodiment of the disclosure;
FIG. 12A illustrates a portion of an adhesive member according to an embodiment of the disclosure;
FIG. 12B is a cross-sectional view taken along line A-A' and line B-B' illustrated in FIG. 12A;
FIG. 13 is a table illustrating a shape of an adhesive member according to various embodiments of the disclosure;
FIG. 14 illustrates a form in which an adhesive member according to an embodiment of the disclosure is attached to a supporting member;
FIG. 15 is a view illustrating disassembly of an electronic device according to an embodiment of the disclosure;
FIG. 16 is a conceptual view illustrating an effect of an adhesive member according to an embodiment of the disclosure; and
FIG. 17 is a view illustrating an effect of an adhesive member according to an embodiment of the disclosure.

### [Mode for Carrying out the Invention]

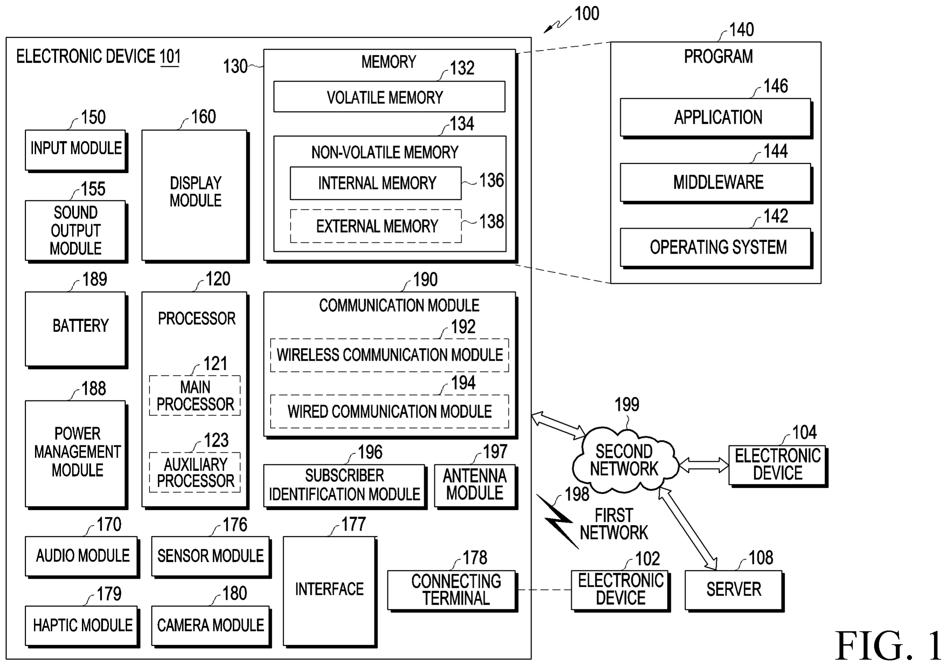

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102 and 104, or the server 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

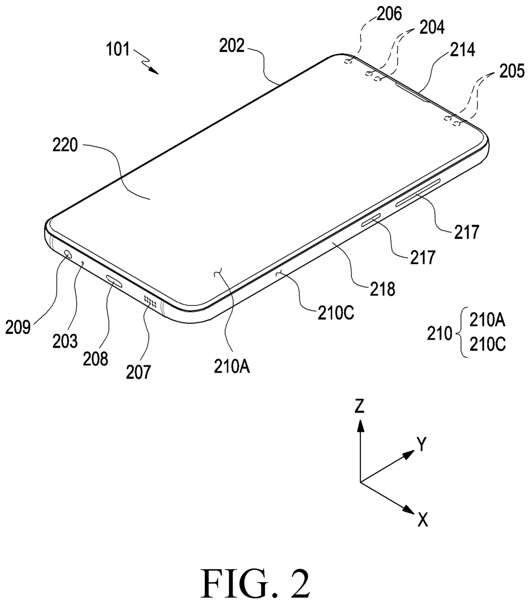

FIG. 2 is a front perspective view illustrating an electronic device according to an embodiment of the disclosure.

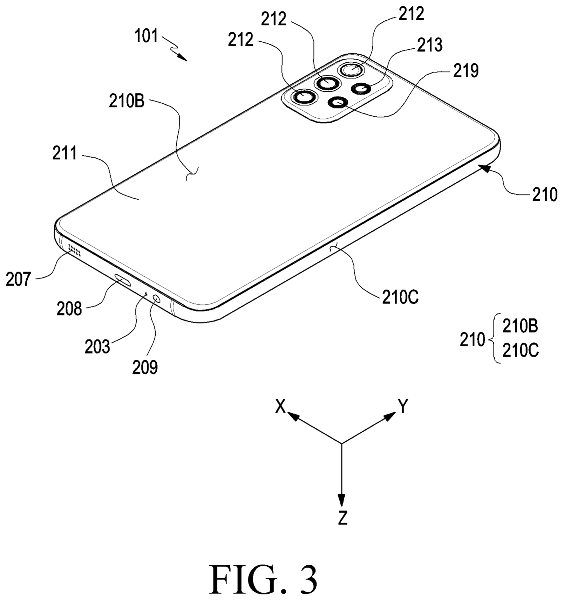

FIG. 3 is a rear perspective view illustrating an electronic device according to an embodiment of the disclosure.

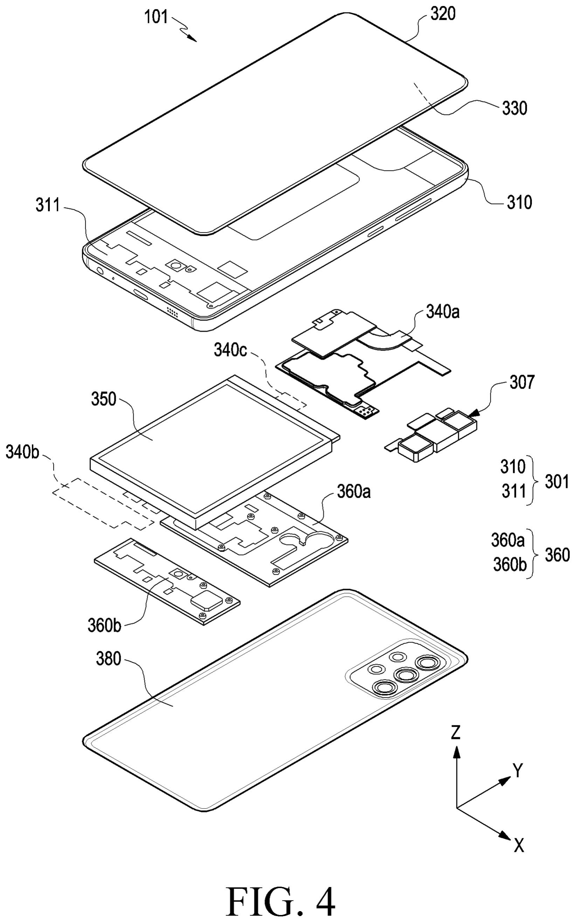

The embodiments of FIGS. 2 and 3 may be combined with the embodiment of FIG. 1 or the embodiments of FIGS. 4 to 11.

Referring to FIGS. 2 and 3, according to an embodiment, an electronic device 101 (e.g., the electronic device 101 of FIG. 1) may include a housing 210 including a first surface (or front surface) 210A, a second surface (or rear surface) 210B, and a side surface 210C surrounding a space between the first surface 210A and the second surface 210B. According to an embodiment (not illustrated), the housing 210 may denote a structure forming the first surface 210A of FIG. 2, the second surface 210B of FIG. 3, and some of the side surfaces 210C. According to an embodiment, at least part of the first surface 210A may have a substantially transparent front plate 202 (e.g., a glass plate or polymer plate including various coat layers). The second surface 210B may be formed by a rear plate 211 that is substantially opaque. The rear plate 211 may be formed of, e.g., laminated or colored glass, ceramic, polymer, metal (e.g., aluminum, stainless steel (STS), or magnesium), or a combination of at least two thereof. The side surface 210C may be formed by a side structure (or "side bezel structure") 218 that couples to the front plate 202 and the rear plate 211 and includes a metal and/or polymer. In an embodiment, the rear plate 211 and the side structure 218 may be integrally formed together and include the same material (e.g., a metal, such as aluminum).

Although not shown, the front plate 202 may include area(s) that bend from at least a portion of an edge toward the rear plate 211 and seamlessly extend. In an embodiment, only one of the areas of the front plate 202 (or the rear plate 211), which bend to the rear plate 211 (or front plate 202) and extend may be included in one edge of the first surface 210A. According to an embodiment, the front plate 202 or the rear plate 211 may have a substantially flat plate shape. For example, no bent and extended area may be included. When an area bending and extending is included, the thickness of the electronic device 101 at the portion including the area bending and extending may be smaller than the thickness of the rest.

According to an embodiment, the electronic device 101 may include at least one or more of a display 220, audio modules 203, 207, and 214, sensor modules 204 and 219, camera modules 205, 212, and 213, key input devices 217, a light emitting device 206, and connector holes 208 and 209. In an embodiment, the electronic device 101 may exclude at least one (e.g., the key input device 217 or the light emitting device 206) of the components or may add other components.

The display 220 may be visually exposed through a significant portion of the front plate 202. In an embodiment, at least a portion of the display 220 may be visually exposed through the front plate 202 forming the first surface 210A, or through a portion of the side surface 210C. In an embodiment, the edge of the display 220 may be formed to be substantially the same in shape as an adjacent outer edge of the front plate 202. In an embodiment (not illustrated), the interval between the outer edge of the display 220 and the outer edge of the front plate 202 may remain substantially even to give a larger area of visual exposure of the display 220.

In an embodiment (not shown), the screen display region of the display 220 may have a recess or opening in a portion thereof, and at least one or more of the audio module 214, sensor module 204, camera module 205, and light emitting device 206 may be aligned with the recess or opening. In an embodiment (not shown), at least one or more of the audio module 214, sensor module 204, camera module 205, fingerprint sensor (not shown), and light emitting device 206 may be included on the rear surface of the screen display area of the display 220. In an embodiment (not illustrated), the display 220 may be disposed to be coupled with, or adjacent, a touch detecting circuit, a pressure sensor capable of measuring the strength (pressure) of touches, and/or a digitizer for detecting a magnetic field-type stylus pen. In an embodiment, at least part of the sensor modules 204 and 219 and/or at least part of the key input devices 217 may be disposed in the first regions 210D and/or the second regions 210E.

The audio modules 203, 207, and 214 may include a microphone hole 203 and speaker holes 207 and 214. A microphone for acquiring external sounds may be disposed in the microphone hole 203. In an embodiment, a plurality of microphones may be disposed to detect the direction of the sound. The speaker holes 207 and 214 may include an external speaker hole 207 and a phone receiver hole 214. In an embodiment, the speaker holes 207 and 214 and the microphone hole 203 may be implemented as a single hole, or speakers may be rested without the speaker holes 207 and 214 (e.g., piezo speakers).

The sensor modules 204 and 219 may generate an electrical signal or data value corresponding to an internal operating state or external environmental state of the electronic device 101. For example, the sensor modules 204 and 219 may include a first sensor module 204 (e.g., a proximity sensor) and/or a second sensor module (not shown) (e.g., a fingerprint sensor), which is disposed on the first surface 210A of the housing 210, and/or a third sensor module 219 and/or a fourth sensor module (e.g., a fingerprint sensor) disposed on the second surface 210B of the housing 210. The fingerprint sensor may be disposed on the second surface 210B or side surface 210C as well as the first surface 210A (e.g., the display 220) of the housing 210. The electronic device 101 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 101, and a second camera device 212 and/or a flash 213 disposed on the second surface 210B. The camera devices 205 and 212 may include one or more lenses, an image sensor, and/or an image signal processor. The flash 213 may include, e.g., a light emitting diode (LED) or a xenon lamp. In an embodiment, two or more lenses (infrared cameras, wide-angle and telephoto lenses) and image sensors may be disposed on one surface of the electronic device 101. In an embodiment, flash 213 may emit infrared light. The infrared light emitted by the flash 213 and reflected by the subject may be received through the third sensor module 219. The electronic device 101 or the processor of the electronic device 101 may detect depth information about the subject based on the time point when the infrared light is received from the third sensor module 219.

The key input device 217 may be disposed on the side surface 210C of the housing 210. In an embodiment, the electronic device 101 may exclude all or some of the above-mentioned key input devices 217 and the excluded key input devices 217 may be implemented in other forms, e.g., as soft keys, on the display 220. In an embodiment, the key input device may include the sensor module disposed on the second surface 210B of the housing 210.

The light emitting device 206 may be disposed on, e.g., the first surface 210A of the housing 210. The light emitting device 206 may provide, e.g., information about the state of the electronic device 101 in the form of light. In an embodiment, the light emitting device 206 may provide a light source that interacts with, e.g., the camera module 205. The light emitting device 206 may include, e.g., an light emitting diode (LED), an infrared (IR) LED, or a xenon lamp.

The connector holes 208 and 209 may include a first connector hole 208 for receiving a connector (e.g., a universal serial bus (USB) connector) for transmitting or receiving power and/or data to/from an external electronic device and/or a second connector hole 209 (e.g., an earphone jack) for receiving a connector for transmitting or receiving audio signals to/from the external electronic device.

FIG. 4 is a front exploded perspective view illustrating an electronic device according to an embodiment of the disclosure.

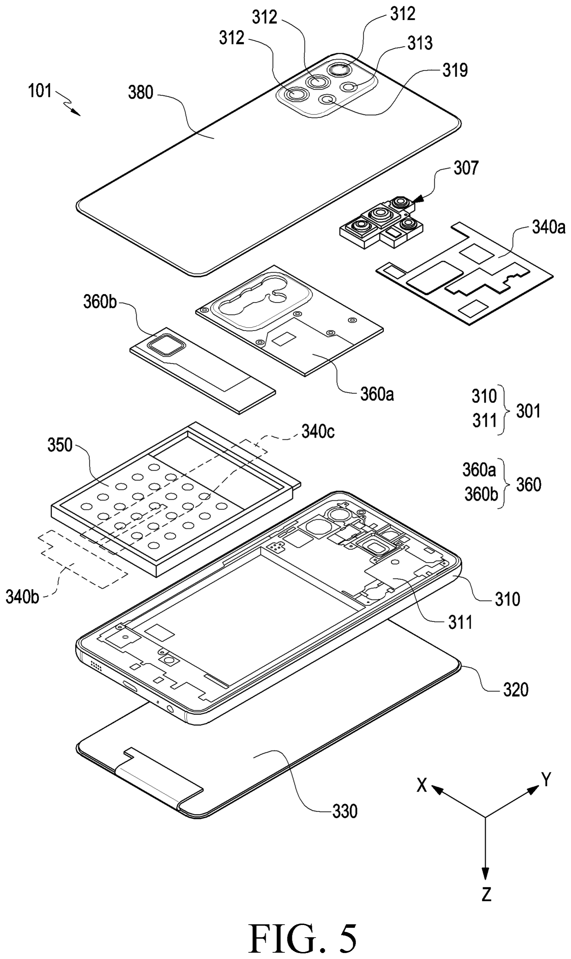

FIG. 5 is a rear exploded perspective view illustrating an electronic device according to an embodiment of the disclosure.

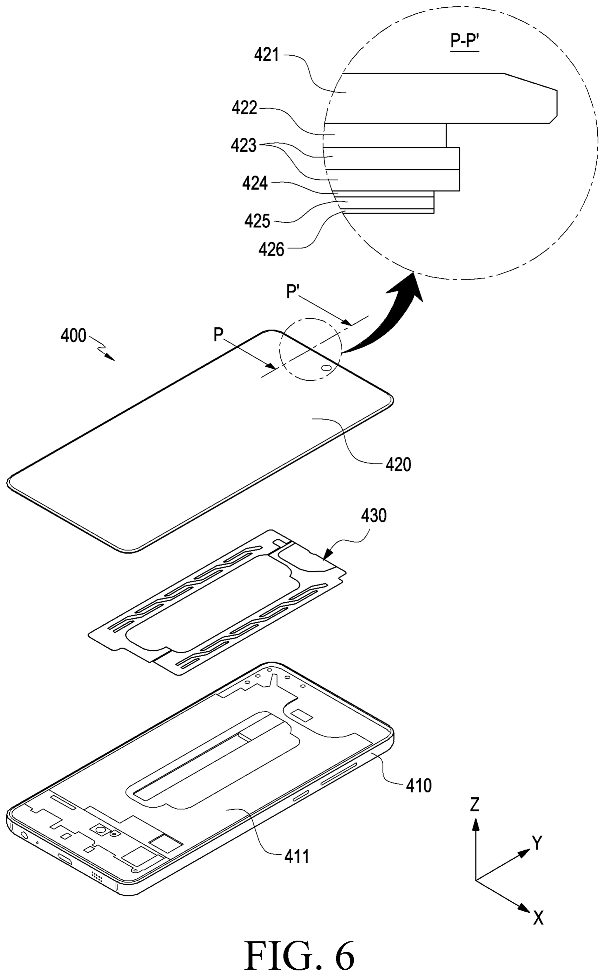

The embodiments of FIGS. 4 to 5 may be combined with the embodiments of FIGS. 1 to 3, or the embodiments of FIGS. 6 to 11.

Referring to FIGS. 3 and 4, an electronic device 101 (e.g., the electronic device 101 of FIG. 1 or FIG. 2) may include a side structure 310, a first supporting member 311 (e.g., a bracket), a front plate 320 (e.g., the front plate 202 of FIG. 1), a display 330 (e.g., the display 220 of FIG. 1), at least one printed circuit board (or a board assembly) 340a or 340b, a battery 350, a second supporting member 360 (e.g., a rear case), an antenna, a camera assembly 307, and a rear plate 380 (e.g., the rear plate 211 of FIG. 2). When the plurality of printed circuit boards 340a and 340b are included, the electronic device 101 may include at least one flexible printed circuit board 340c to electrically connect different printed circuit boards. For example, the printed circuit boards 340a and 340b may include a first circuit board 340a disposed above the battery 350 and a second circuit board 340b disposed under the battery 350, and the flexible circuit board 340c may electrically connect the first circuit board 340a and the second circuit board 340b.

According to an embodiment, the electronic device 101 may exclude at least one (e.g., the first supporting member 311 or the second supporting member 360) of the components or may add other components. At least one of the components of the electronic device 101 may be the same or similar to at least one of the components of the electronic device 101 of FIG. 1 or 2 and no duplicate description is made below.

At least a portion of the first supporting member 311 may be provided in a flat plate shape. In an embodiment, the first supporting member 311 may be disposed inside the electronic device 101 to be connected with the side structure 310 or integrated with the side structure 310. The first supporting member 311 may be formed of, e.g., a metallic material and/or non-metallic material (e.g., polymer). When the first supporting member 311 is at least partially formed of a metallic material, a portion of the side structure 310 or the first supporting member 311 may function as an antenna. The display 330 may be joined onto one surface of the first supporting member 311, and the printed circuit boards 340a and 340b may be joined onto the opposite surface of the first supporting member 311. A processor, memory, and/or interface may be mounted on the printed circuit boards 340a and 340b. The processor may include one or more of, e.g., a central processing unit, an application processor, a graphic processing device, an image signal processing, a sensor hub processor, or a communication processor.

According to an embodiment, the first supporting member 311 and the side structure 310 may be collectively referred to as a front case or a housing 301. According to an embodiment, the housing 301 may be generally understood as a structure for receiving, protecting, or disposing the printed circuit boards 340a and 340b or the battery 350. In an embodiment, the housing 301 may be understood as including a structure that the user may visually or tactfully recognize from the exterior of the electronic device 101, e.g., the side structure 310, the front plate 320, and/or the rear plate 380. In an embodiment, the 'front or rear surface of the housing 301' may refer to the first surface 210A of FIG. 1 or the second surface 210B of FIG. 2. In an embodiment, the first supporting member 311 may be disposed between the front plate 320 (e.g., the first surface 210A of FIG. 1) and the rear plate 380 (e.g., the second surface 210B of FIG. 2) and may function as a structure for placing an electrical/electronic component, such as the printed circuit boards 340a and 340b or the camera assembly 307.

The memory may include, e.g., a volatile or non-volatile memory.

The interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

The second supporting member 360 may include, e.g., an upper supporting member 360a and a lower supporting member 360b. In an embodiment, the upper supporting member 360a, together with a portion of the first supporting member 311, may be disposed to surround the printed circuit boards 340a and 340b (e.g., the first circuit board 340a). For example, the upper supporting member 360a of the second supporting member 360 may be disposed to face the first supporting member 311 with the first circuit board 340a interposed therebetween. In an embodiment, the lower supporting member 360b of the second supporting member 360 may be disposed to face the first supporting member 311 with the second circuit board 340b interposed therebetween. A circuit device (e.g., a processor, a communication module, or memory) implemented in the form of an integrated circuit chip or various electrical/electronic components may be disposed on the printed circuit boards 340a and 340b. According to an embodiment, the printed circuit boards 340a and 340b may receive an electromagnetic shielding environment from the second supporting member 360. In an embodiment, the lower supporting member 360b may be utilized as a structure in which electrical/electronic components, such as a speaker module and an interface (e.g., a USB connector, an SD card/MMC connector, or an audio connector) may be disposed. In an embodiment, electrical/electronic components, such as a speaker module and an interface (e.g., a USB connector, an SD card/MMC connector, or an audio connector) may be disposed on an additional printed circuit board (not shown). For example, the lower supporting member 360b, together with the other part of the first supporting member 311, may be disposed to surround the additional printed circuit board. The speaker module or interface disposed on the additional printed circuit board (not shown) or the lower supporting member 360b may be disposed corresponding to the audio module 207 or connector holes 208 and 309 of FIG. 1.

The battery 350 may be a device for supplying power to at least one component of the electronic device 101. The battery 350 may include, e.g., a primary cell which is not rechargeable, a secondary cell which is rechargeable, or a fuel cell. At least a portion of the battery 350 may be disposed on substantially the same plane as the printed circuit boards 340a and 340b. The battery 350 may be integrally or detachably disposed inside the electronic device 101.

Although not shown, the antenna may include a conductor pattern implemented on the surface of the second supporting member 360 through, e.g., laser direct structuring. In an embodiment, the antenna may include a printed circuit pattern formed on the surface of the thin film. The thin film-type antenna may be disposed between the rear plate 380 and the battery 350. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the present invention, another antenna structure may be formed by a portion or combination of the side structure 310 and/or the first supporting member 311.

According to an embodiment, the camera assembly may include at least one camera module. Inside the electronic device 101, the camera assembly 307 (or at least one camera module) may receive at least a portion of the light incident through the optical hole or camera windows. In an embodiment, the camera assembly 307 may be disposed on the first supporting member 311 in a position adjacent to the printed circuit boards 340a and 340b. In an embodiment, the camera module(s) of the camera assembly 307 may be generally aligned with either one of the camera windows and be at least partially surrounded by the second supporting member 360 (e.g., the upper supporting member 360a).

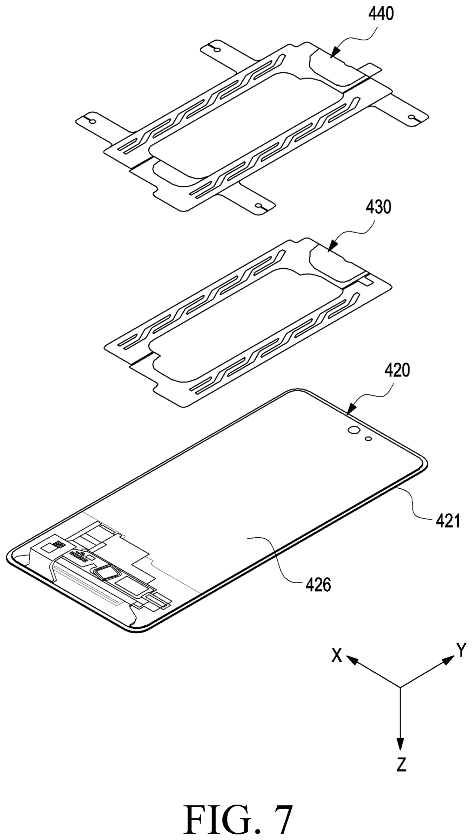

FIG. 6 illustrates that the display 420 and the adhesive member 430 according to an embodiment of the disclosure are separated from the housing 410. Some or all of the components described with reference to FIG. 6 may be the same as all or some of the components described with reference to FIGS. 1 to 5. Some or all of the components described with reference to FIG. 6 may be the same as all or some of the components described with reference to FIGS. 7 to 17.

According to an embodiment, the electronic device 400 may include a housing 410. The housing 410 may provide a space in which the components of the electronic device 400 are received. The description of the housing 410 may be the same as the description of the housing (e.g., 210 of FIG. 2 and 301 of FIG. 5) described with reference to FIGS. 1 to 5.

According to an embodiment, the housing 410 may include a supporting member 411. The supporting member 411 may be disposed inside the housing 410. The display 420 may be mounted on the supporting member 411. The description of the supporting member 411 may be the same as the description of the supporting member (e.g., 311 of FIG. 5) described with reference to FIGS. 1 to 5.

According to an embodiment, the electronic device 400 may include a display 420. The display 420 may be coupled to the housing 410. The display 420 may be coupled to the supporting member 411 through the adhesive member 430. The display 420 may be exposed to the outside of the housing 410. The description of the display 420 may be the same as the description of the display (e.g., 220 of FIG. 2 and 330 of FIG. 5) described with reference to FIGS. 1 to 5.

According to an embodiment, the electronic device 400 may include an adhesive member 430. The adhesive member 430 may couple the supporting member 411 to the display 420. One surface of the adhesive member 430 may be attached to the supporting member 411, and the other surface thereof may be attached to the display 420. The adhesive member 430 may be disposed between the supporting member 411 and the display 420.

According to an embodiment, the display 420 may include a window 421. The window 421 may display a screen outside the electronic device 400. The display 420 may include an outer film 422. The outer film 422 may be disposed between the window 421 and the panel 423. The outer film 422 may couple the window 421 and the panel 423. The outer film 422 may be a film layer to which an on-cell touch AMOLED (OCTA) is applied. The display 420 may include a panel 423. The panel 423 may output a screen by receiving an electrical signal. The display 420 may include an adhesive layer 424 and a buffer layer 425. The adhesive layer 424 may couple the panel 423 and the buffer layer 425. The buffer layer 425 may be formed of a sponge material. The display 420 may include an inner film 426. The inner film 426 may be referred to as a "film". The film 426 may be coupled to the buffer layer 425. The film 426 may be a thin sheet formed of a copper (Cu) material. The film 426 may remove electromagnetic noise generated from the outer film 422 and the panel 423.

According to an embodiment, the adhesive member 430 may couple the supporting member 411 to the film 426. One surface of the adhesive member 430 may be attached to the film 426, and the other surface thereof may be attached to the supporting member 411.

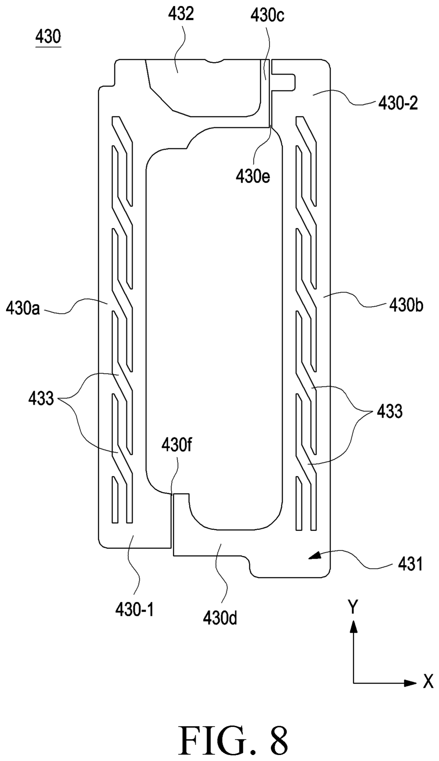

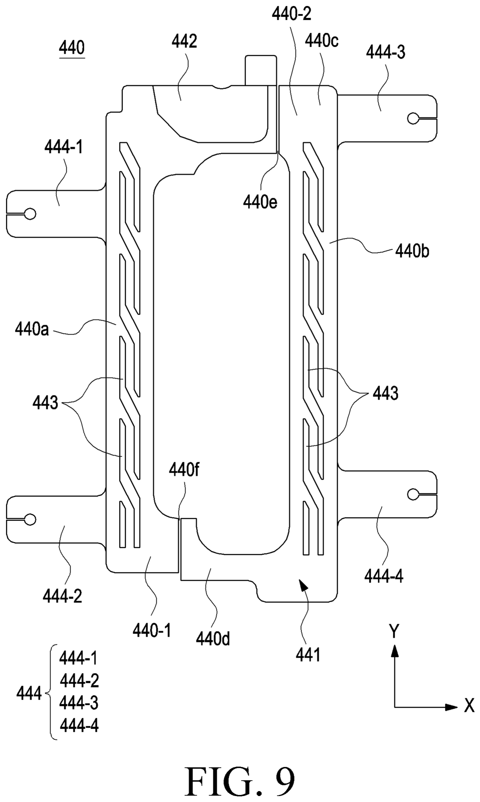

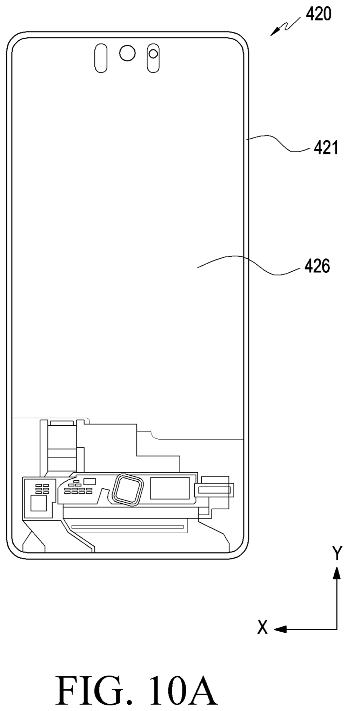

FIG. 7 is a view illustrating that the display 420, the adhesive member 430, and the release sheet 440 are separated. FIG. 8 illustrates that only the adhesive member 430 is separated. FIG. 9 illustrates that only the release sheet 440 is separated. Some or all of the components described with reference to FIGS. 7 to 9 may be the same as those described with reference to FIGS. 1 to 6. Some or all of the components described with reference to FIGS. 7 to 9 may be the same as those described with reference to FIGS. 10A to 17.

According to an embodiment, the electronic device 400 may include a display 420, an adhesive member 430, and a release sheet 440. The adhesive member 430 may be attached to one surface (e.g., the film 426) of the display 420. The release sheet 440 may be coupled to the adhesive member 430 to be detachable from the adhesive member 430. A portion of the release sheet 440 may have a shape corresponding to the adhesive member 430.

According to an embodiment, the adhesive member 430 may have a rectangular closed loop shape. The adhesive member 430 may include an adhesive portion 431 having adhesive properties. Two opposite surfaces of the adhesive portion 431 may be formed of a material having adhesive properties. The adhesive member 430 may include a non-adhesive portion 432. The non-adhesive portion 432 may be formed of a non-adhesive material. The non-adhesive portion 432 may be a portion of the adhesive member 430 facing the electronic component (not illustrated) disposed on the supporting member (e.g., 411 of FIG. 6). The adhesive member 430 may include a plurality of slits 433. The plurality of slits 433 may be spaced apart from each other along the direction in which the adhesive portion 431 extends. According to an embodiment, the adhesive member 430 may be formed of a plurality of adhesive members 430-1 and 430-2. For example, the adhesive member 430 may form a closed loop by a first adhesive member 430-1 and a second adhesive member 430-2.

According to an embodiment, the adhesive member 430 may include a plurality of parts (e.g., 430-1 and 430-2). The plurality of parts (e.g., 430-1 and 430-2) may form a closed loop. The adhesive member 430 may include a first adhesive member 430-1. The adhesive member 430 may include a second adhesive member 430-2. The adhesive member 430 may have gaps 430e and 430f. The gaps 430e and 430f may be formed between the first adhesive member 430-1 and the second adhesive member 430-2. The adhesive member 430 may include a first gap 430e formed between the second adhesive portion 430b and the third adhesive portion 430c. The adhesive member 430 may include a second gap 430f formed between the first adhesive portion 430a and the fourth adhesive portion 430d. The gaps 430e and 430f may be referred to as "slits".

According to an embodiment, the adhesive member 430 may include a first adhesive portion 430a, a second adhesive portion 430b, a third adhesive portion 430c, and a fourth adhesive portion 430d. The first adhesive portion 430a and the second adhesive portion 430b may form a long side of the adhesive member 430. The first adhesive portion 430a and the second adhesive portion 430b may be referred to as a "side adhesive portion". The third adhesive portion 430c and the fourth adhesive portion 430d may form a short side of the adhesive member 430. The plurality of slits 433 may be formed in the side adhesive portions 430a and 430b. The plurality of slits 433 may be disposed along a direction in which the side adhesive portions 430a and 430b extend. According to an embodiment, the first adhesive portion 430a and the third adhesive portion 430c may be integrally formed. The second adhesive portion 430b and the fourth adhesive portion 430d may be integrally formed. For example, a slit 430f may be formed between the first adhesive portion 430a and the fourth adhesive portion 430d. For example, a slit 430e may be formed between the second adhesive portion 430b and the third adhesive portion 430c.

According to an embodiment, the release sheet 440 may have a rectangular closed loop shape. A portion of the release sheet 440 may have a shape corresponding to the adhesive member 430. The release sheet 440 may include a first cover portion 441 covering the adhesive portion 431. One surface of the first cover portion 441 may be attached to the adhesive portion 431. The release sheet 440 may include a second cover portion 442 covering the non-adhesive portion 432. The second cover portion 442 may correspond to the non-adhesive portion 432. The release sheet 440 may include a plurality of slit covers 443. The plurality of slit covers 443 may be formed to respectively correspond to the plurality of slits 433. According to an embodiment, the release sheet 440 may be formed of a plurality of release sheets 440-1 and 440-2. For example, the release sheet 440 may form a closed loop by the first release sheet 440-1 and the second release sheet 440-2.

According to an embodiment, the release sheet 440 may include a plurality of parts (e.g., 440-1 and 440-2). The plurality of parts (e.g., 440-1 and 440-2) may form a closed loop. The release sheet 440 may include the first release sheet 440-1. The release sheet 440 may include the second release sheet 440-2. The release sheet 440 may have gaps 440e and 440f. The gaps 440e and 440f may be formed between the first release sheet 440-1 and the second release sheet 440-2. The release sheet 440 may include a first gap 440e formed between the second release portion 440b and the third release portion 440c. The release sheet 440 may include a second gap 440f formed between the first release portion 440a and the fourth release portion 440d. The gaps 440e and 440f may be referred to as "slits".

According to an embodiment, the first release sheet 440-1 may have a shape corresponding to that of the first adhesive member 430-1. The second release sheet 440-2 may have a shape corresponding to the second adhesive member 430-2. The gaps 430e and 430f of the adhesive member 430 may correspond to the gaps 440e and 440f of the release sheet 440.

According to an embodiment, the release sheet 440 may include a first release portion 440a, a second release portion 440b, a third release portion 440c, and a fourth release portion 440d. The first release portion 440a and the second release portion 440b may form a long side of the release sheet 440. The first release portion 440a and the second release portion 440b may be referred to as a "side release portion". The third release portion 440c and the fourth release portion 440d may form a short side of the release sheet 440. The plurality of slit covers 443 may be formed on the side release portions 440a and 440b. The plurality of slit covers 443 may be disposed along a direction in which the side release portions 440a and 440b extend.

According to an embodiment, the release sheet 440 may include a gripping portion 444. The gripping portion 444 may protrude to the outside of the first cover portion 441. A plurality of gripping portions 444 may be formed to be spaced apart from each other in the circumferential direction of the release sheet 440.

According to an embodiment, the gripping portion 444 may include a first gripping portion 444-1. The first gripping portion 444-1 may protrude from the first release portion 440a. The gripping portion 444 may include a second gripping portion 444-2. The second gripping portion 444-2 may protrude from the first release portion 440a. The first gripping portion 444-1 and the second gripping portion 444-2 may be spaced apart from each other in the length direction (e.g., the Y direction) of the adhesive member 430. The first gripping portion 444-1 and the second gripping portion 444-2 may extend in directions parallel to each other (e.g., the X direction).

According to an embodiment, the gripping portion 444 may include a third gripping portion 444-3. The third gripping portion 444-3 may protrude from the second release portion 440b. The gripping portion 444 may include a fourth gripping portion 444-4. The fourth gripping portion 444-4 may protrude from the second release portion 440b. The third gripping portion 444-3 and the fourth gripping portion 444-4 may be spaced apart from each other in the length direction (e.g., the Y direction) of the adhesive member 430. The third gripping portion 444-3 and the fourth gripping portion 444-4 may extend in directions parallel to each other (e.g., the X direction).

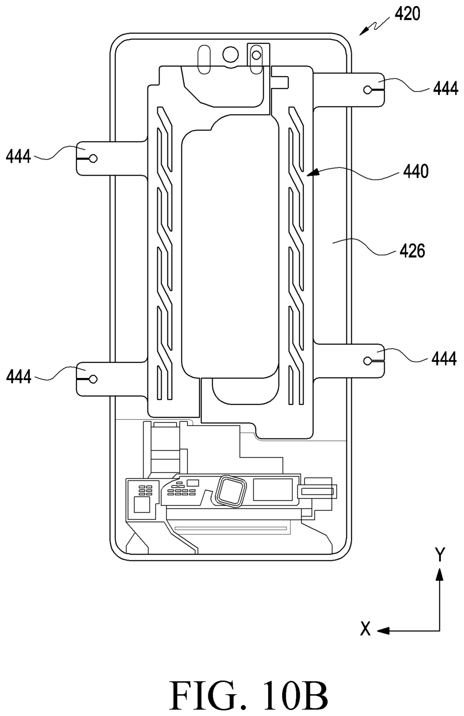

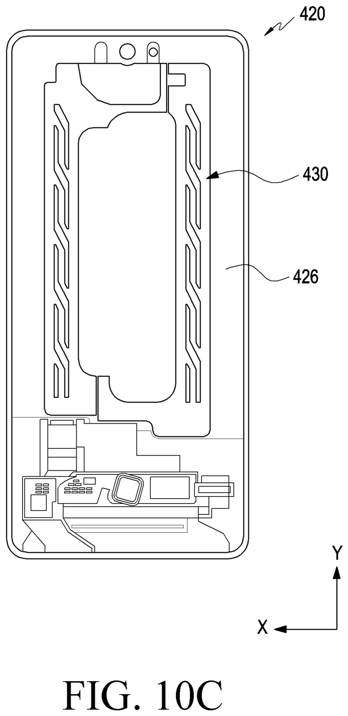

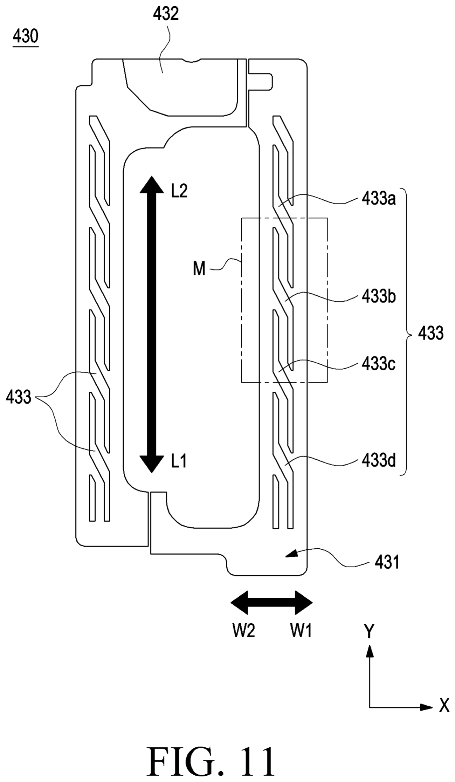

FIG. 10A illustrates one surface of the display 420 before the adhesive member 430 and the release sheet 440 are attached. FIG. 10B illustrates one surface of the display 420 after the adhesive member 430 and the release sheet 440 are attached. FIG. 10C illustrates a state in which the release sheet 440 is removed from the state of FIG. 10B. Some or all of the components described with reference to FIGS. 10A to 10C may be the same as those described with reference to FIGS. 1 to 9. Some or all of the components described with reference to FIGS. 10A to 10C may be the same as those described with reference to FIGS. 11 to 17.

According to an embodiment, the adhesive member 430 and the release sheet 440 may be attached to the display 420. The adhesive member 430 may be attached to the film 426. While the adhesive member 430 and the release sheet 440 are attached to the display 420, the gripping portion 444 may protrude to the outside of the display 420. The user may separate the release sheet 440 from the adhesive member 430 by gripping the gripping portion 444. After the release sheet 440 is separated from the adhesive member 430, the adhesive member 430 may be attached to the supporting member 411 (e.g., 411 of FIG. 6) of the housing 410 (e.g., 410 of FIG. 6).

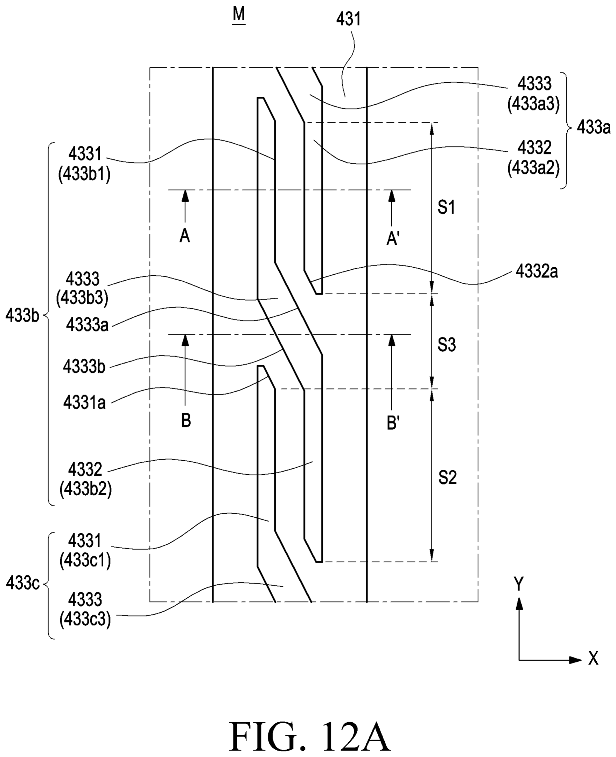

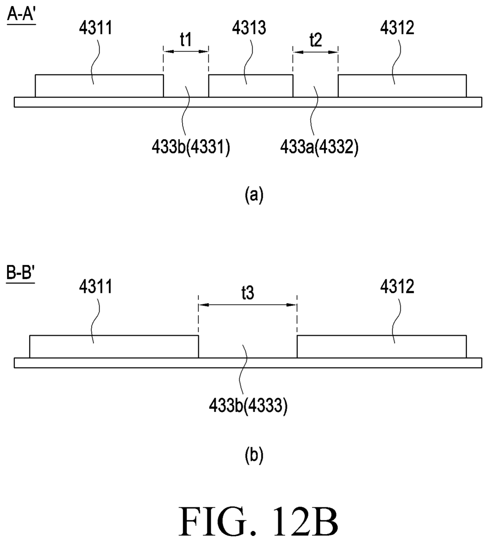

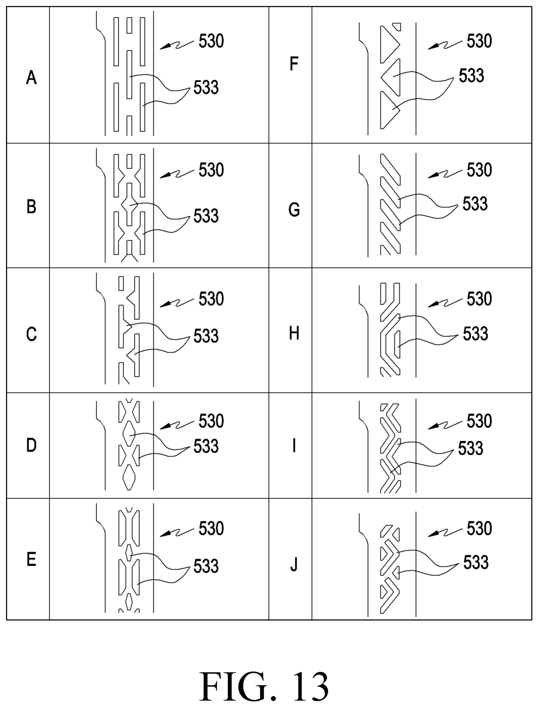

FIG. 11 illustrates that only the adhesive member 430 is separated. FIG. 12A is an enlarged view illustrating a portion of the adhesive member 430. FIG. 12B is a cross-sectional view taken along line A-A' and line B-B' illustrated in FIG. 12A. Some or all of the components described with reference to FIGS. 11 to 12B may be the same as the components described with reference to FIGS. 1 to 10C. Some or all of the components described with reference to FIGS. 11 to 12B may be the same as those described with reference to FIGS. 13 to 17.

According to an embodiment, the adhesive member 430 may include a plurality of slits 433. The plurality of slits 433 may be formed to be open in the adhesive portion 431. The plurality of slits 433 may be disposed along the first direction (e.g., L1). The plurality of slits 433 may be disposed along a second direction (e.g., L2) opposite to the first direction (e.g., L1). The first direction L1 and the second direction L2 may be defined as a "length direction". The length direction may be a direction in which the supporting member (e.g., 411 of FIG. 6) extends (e.g., the Y direction illustrated in FIGS. 2 to 17). The plurality of slits 433 may be arranged along the length direction L1 or L2 and may be spaced apart from each other in the length direction L1 or L2.

According to an embodiment, the plurality of slits 433 may be spaced apart from each other in a third direction (e.g., W1). The plurality of slits 433 may be spaced apart from each other in a fourth direction (e.g., W2) opposite to the third direction (e.g., W1). The third direction W1 and the fourth direction W2 may be defined as a "width direction". The width direction may be defined as a direction (e.g., the X direction in FIGS. 2 to 17) crossing the length direction. The width direction may be orthogonal to the length direction. The plurality of adjacent slits 433 may be spaced apart from each other in the width direction W1 or W2.

According to an embodiment, the length direction of the adhesive member 430 may be defined as the first direction, and the width direction of the adhesive member 430 may be defined as the second direction. The first direction and the second direction may cross each other (substantially orthogonal). As illustrated in FIG. 11, the first direction may be a direction (e.g., L1 or L2) in which the plurality of slits 433 are arranged. As illustrated in FIG. 11, the second direction may be a direction (e.g., W1 or W2) crossing the first direction. As illustrated in FIGS. 2 to 5, the first direction may be a direction (e.g., the Y direction) in which the plates 320 and 380 or the display 330 extend. As illustrated in FIGS. 2 to 5, the second direction may be a direction (e.g., the X direction) crossing the first direction (e.g., the Y direction).

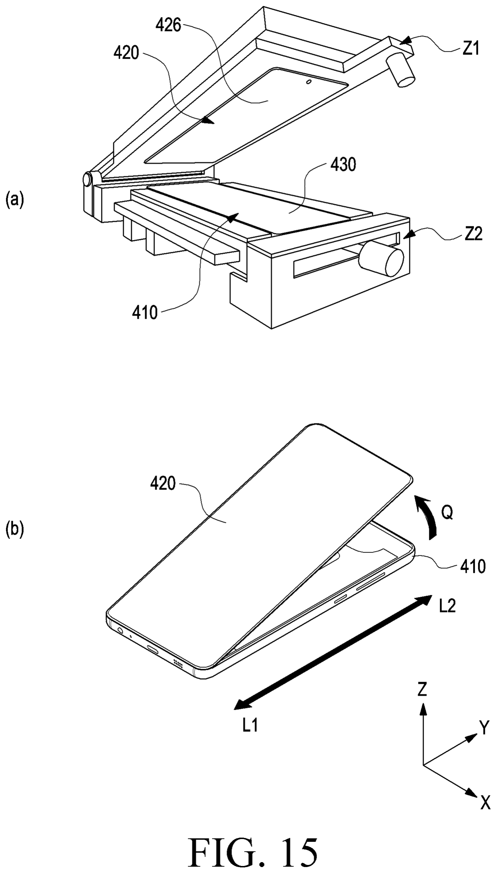

According to an embodiment, the plurality of slits 433 may include first to fourth slits 433a, 433b, 433c, and 433d. The first to fourth slits 433a, 433b, 433c, and 433d may be sequentially arranged in the length direction L1. Referring to FIG. 15, the plurality of slits 433 may be separated from the film 426 in the order arranged along the length direction L1. When the adhesive member 430 is separated from the film 426, the first slit 433a may be separated from the film 426 before the second to fourth slits 433b, 433c, and 433d. When the adhesive member 430 is separated from the film 426, the fourth slit 433d may be separated from the film 426 later than the first to third slits 433a, 433b, and 433c.

According to an embodiment, the first slit 433a among the plurality of slits 433 may be referred to as a "preceding slit". The second slit 433b among the plurality of slits 433 may be referred to as a "middle slit." Among the plurality of slits 433, the third slit 433c may be referred to as a "following slit."

According to an embodiment, the slit 433 may include a first slit portion 4331. The first slit portion 4331 may extend along the first direction L1. The first slit portion 4331 may extend along the length direction (e.g., L1 or L2) of the adhesive member 430. Each of the first to fourth slits 433a, 433b, 433c, and 433d may include a first slit portion 4331. For example, the first slit portion 4331 of the second slit 433b may be referred to as a "2-1th slit portion 433b1". For example, the first slit portion 4331 of the third slit 433c may be referred to as a 3-1th slit portion 433c1.

According to an embodiment, the slit 433 may include a second slit portion 4332. The second slit portion 4332 may extend along the first direction L1. The second slit portion 4332 may extend along the length direction (e.g., L1 or L2) of the adhesive member 430. Each of the first to fourth slits 433a, 433b, 433c, and 433d may include a second slit portion 4332. For example, the second slit portion 4332 of the first slit 433a may be referred to as a "1-2th slit portion 433a2". For example, the second slit portion 4332 of the second slit 433b may be referred to as a "2-2th slit portion 433b2".

According to an embodiment, the first slit portion 4331 and the second slit portion 4332 may have a spacing interval in the length direction (e.g., L1 or L2). The first slit portion 4331 and the second slit portion 4332 may have a spacing interval in the width direction (e.g., W1 or W2).

According to an embodiment, the slit 433 may include a third slit portion 4333. The third slit portion 4333 may connect the first slit portion 4331 and the second slit portion 4332. The third slit portion 4333 may extend obliquely with respect to the length direction (e.g., L1 or L2). The third slit portion 4333 may extend obliquely with respect to the width direction (e.g., W1 or W2). Each of the first to fourth slits 433a, 433b, 433c, and 433d may include a third slit portion 4333. For example, the third slit portion 4333 of the first slit 433a may be referred to as a "1-3th slit portion 433a3". For example, the third slit portion 4333 of the second slit 433b may be referred to as a 2-3th slit portion 433b3. For example, the third slit portion 4333 of the third slit 433c may be referred to as a "3-3th slit portion 433c3".

According to an embodiment, the first slit portion 4331 may include a first edge 4331a. The second slit portion 4332 may include a second edge 4332a. The third slit portion 4333 may include a first inclined surface 4333a. The third slit portion 4333 may include a second inclined surface 4333b. The first edge 4331a may face the second inclined surface 4333b of the adjacent slit 433. The first edge 4331a may be inclined in parallel with the direction in which the second inclined surface 4333b of the adjacent slit 433 is inclined. The second edge 4332a may face the first inclined surface 4333a of the adjacent slit 433. The second edge 4332a may be inclined in parallel with the direction in which the first inclined surface 4333a of the adjacent slit 433 is inclined.

According to an embodiment, the slit 433 may be continuous in the length direction (e.g., L1 or L2) of the adhesive member 430. The adhesive portion 431 in which the slit 433 is not formed in the length direction (e.g., L1 or L2) of the adhesive member 430 may not be present. At least a portion of the slit 433 may be positioned in the width direction (e.g., W1 or W2) at a predetermined portion of the adhesive member 430.

According to an embodiment, the first slit portion 4331 (e.g., the 2-1th slit portion 433b1) of any one (e.g., the second slit 433b) of the plurality of slits 433 may be spaced apart from the second slit portion 4332 (e.g., the 1-2th slit portion 433a2) of the adjacent other (e.g., the first slit 433a) of the plurality of slits 433 in the width direction W1. The second slit portion 4332 (e.g., the 2-2th slit portion 433b2) of any one (e.g., the second slit 433b) of the plurality of slits 433 may be spaced apart from the first slit portion 4331 (e.g., the 3-1th slit portion 433c1) of the adjacent other (e.g., the third slit 433c) of the plurality of slits 433 in the width direction W2. The third slit portion 4333 (e.g., the 2-3th slit portion 433b3) of any one (e.g., the second slit 433b) of the plurality of slits 433 may be spaced apart from the first slit portion 4331 (e.g., the 3-1th slit portion 433c1) of the adjacent other (e.g., the third slit 433c) and the second slit portion 4332 (e.g., the 1-2th slit portion 433a2) of the adjacent still other (e.g., the first slit 433a) of the plurality of slits 433 in the length direction L1 or L2. The third slit portion 4333 (e.g., the 2-3th slit portion 433b3) of any one (e.g., the second slit 433b) of the plurality of slits 433 may be positioned between the first slit portion 4331 (e.g., the 3-1th slit portion 433c1) of the adjacent other (e.g., the third slit 433c) and the second slit portion 4332 (e.g., the 1-2th slit portion 433a2) of the adjacent still other (e.g., the first slit 433a) of the plurality of slits 433.

According to an embodiment, the first slit portion 4331 of each of the plurality of slits 433a, 433b, 433c and 433d may be arranged along the length direction L1. The respective first slit portions 4331 of the plurality of slits 433a, 433b, 433c, and 433d may be spaced apart from each other in the length direction L1.

According to an embodiment, the first slit portion 4331 of the first slit 433a may be referred to as a "1-1th slit portion 433a1". The first slit portion 4331 of the second slit 433b may be referred to as a "2-1th slit portion 433b1".

According to an embodiment, the respective second slit portions 4332 of the plurality of slits 433a, 433b, 433c and 433d may be arranged along the length direction L1. The respective second slit portions 4332 of the plurality of slits 433a, 433b, 433c, and 433d may be spaced apart from each other in the length direction L1.

According to an embodiment, the second slit portion 4332 of the first slit 433a may be referred to as a "1-2th slit portion 433a2". The second slit portion 4332 of the second slit 433b may be referred to as a "2-2th slit portion 433b2".

According to an embodiment, the respective third slit portions 4333 of the plurality of slits 433a, 433b, 433c and 433d may be arranged along the length direction L1. The respective third slit portions 4333 of the plurality of slits 433a, 433b, 433c and 433d may be spaced apart from each other in the length direction L1.

According to an embodiment, the third slit portion 4333 of the first slit 433a may be referred to as a "1-3th slit portion 433a3". The third slit portion 4333 of the second slit 433b may be referred to as a "2-3th slit portion 433b3".

According to an embodiment, the adhesive member 430 may include a first section S1. The first section S1 may mean an area in which the first slit portion of any one of the plurality of slits 433 and the second slit portion 4332 of another one thereof are positioned. In the first section S1, the first slit portion 4331 of any one of the plurality of slits 433 and the second slit portion 4332 of another one thereof may be spaced apart from each other in the width direction W1 or W2. The first section S1 may be referred to as an "overlapping section".

According to an embodiment, the adhesive member 430 may include a second section S2. The second section S2 may mean an area in which the first slit portion of any one of the plurality of slits 433 and the second slit portion 4332 of another one thereof are positioned. In the second section S2, the first slit portion 4331 of any one of the plurality of slits 433 and the second slit portion 4332 of another one thereof may be spaced apart from each other in the width direction W1 or W2. The second section S2 may be referred to as an "overlapping section".

According to an embodiment, the adhesive member 430 may include a third section S3. The third section S3 may mean an area in which the third slit portion of any one of the plurality of slits 433 is positioned. In the third section S3, only the third slit portion 4333 of any one of the plurality of slits 433 may be positioned in the width direction W1 or W2. The first edge 4331a or the second edge 4332a of the adjacent slit 433 may be positioned in the third section S3.

According to an embodiment, when the adhesive member 430 is cut (e.g., cut along the line A-A') in the width direction W1 or W2 in the first section S1, the second slit portion 4332 of the preceding slit 433a and the first slit portion 4331 of the middle slit 433b may be spaced apart from each other. The adhesive member 430 may include a first adhesive area 4311 and a second adhesive area 4312. The second slit portion 4332 of the preceding slit 433a and the first slit portion 4331 of the middle slit 433b may be formed between the first adhesive area 4311 and the second adhesive area 4312. The adhesive member 430 may include a third adhesive area 4313. The third adhesive area 4313 may be formed between the second slit portion 4332 of the preceding slit 433a and the first slit portion 4331 of the middle slit 433b. The first adhesive area 4311 and the third adhesive area 4313 may be spaced apart from each other with an interval t1 therebetween, and the first slit portion 4331 of the middle slit 433b may form the interval t1. The second adhesive area 4312 and the third adhesive area 4313 may be spaced apart from each other with an interval t2 therebetween, and the second slit portion 4332 of the preceding slit 433a may form the interval t2. Descriptions (e.g., 4311, 4312, 4313, t1, and t2) of the above-described structures in the first section S1 may be equally applied to the second section S2. For example, the third adhesive area 4313 may be formed between the second slit portion 4332 of the middle slit 433b and the first slit portion 4331 of the following slit 433c.

According to an embodiment, when the adhesive member 430 is cut (e.g., cut along the line B-B') in the width direction W1 or W2 in the third section S3, the third slit portion 4333 of the middle slit 433b may be positioned. The adhesive member 430 may include a first adhesive area 4311 and a second adhesive area 4312. The third slit portion 4333 of the middle slit 433b may be formed between the first adhesive area 4311 and the second adhesive area 4312. The first adhesive area 4311 and the second adhesive area 4312 may be spaced apart from each other with an interval t3 interposed therebetween, and the third slit portion 4333 of the middle slit 433b may form the interval t3.

According to an embodiment, the width t1 of the first slit portion 4331 may be smaller than the width t3 of the third slit portion 4333. The width t2 of the second slit portion 4332 may be smaller than the width t3 of the third slit portion 4333. The width t1 of the first slit portion 4331 may be in a range of 0.8 mm to 1.2 mm. The width t2 of the second slit portion 4332 may be in a range of 0.8 mm to 1.2 mm. The width t3 of the third slit portion 4333 may be in a range of 1.8 mm to 2.2 mm. By forming the width t3 of the third slit portion 4333 to be larger than the first and second slit portions 4331 and 4332, it is possible to maintain a constant width occupied by the adhesive areas 4311, 4312 and 4313 in the first to third sections S1, S2, and S3. For example, the sum of the widths of the adhesive areas 4311, 4312 and 4313 in the first to third sections S1, S2 and S3 may be in a range of 7.8mm to 8.2mm. Since the widths of the adhesive areas 4311, 4312 and 4313 are maintained constant in the length direction L1 of the adhesive member 430, when the adhesive member 430 is separated from the film 426, the stress acting on the adhesive areas 4311, 4312 and 4313 is dispersed, preventing delamination of the film 426.

FIG. 13 is a table illustrating adhesive members 530 including slits 533 according to various embodiments of the disclosure. The components described with reference to FIG. 13 may be identical in whole or part to the components described with reference to FIGS. 1 to 12B.

According to various embodiments, the adhesive member 530 may include a plurality of slits 533. Each of the plurality of slits 533 and its adjacent slit may be arranged in the length direction of the adhesive member 530. Along the length direction of the adhesive member 530, at least a portion of the plurality of slits 533 may be formed in at least a portion of the adhesive member 530. At least a portion of the plurality of slits 533 may be continuous along the length direction of the adhesive member 530. For example, as in embodiment A, the plurality of slits 533 extending in the length direction of the adhesive member 530 may be spaced apart from each other in the width direction and the length direction of the adhesive member 530, and may be alternately arranged along the length direction. For example, as in embodiment F, the plurality of slits 533 may be triangular with a height in the width direction, and the vertex positions of adjacent slits 533 may be alternately arranged in the length direction of the adhesive member 530.

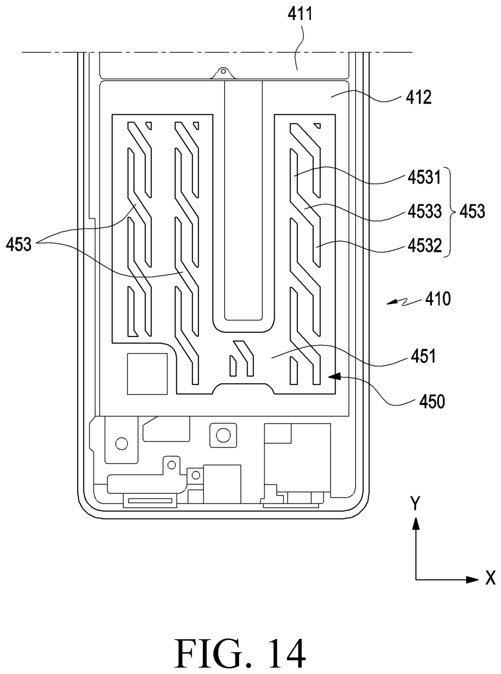

FIG. 14 illustrates a form in which the adhesive member 450 is coupled to the supporting member 411, according to an embodiment of the disclosure. Some or all of the elements described with reference to FIG. 14 may be the same as those described with reference to FIGS. 1 to 13.

According to an embodiment, a housing 410 may include a supporting member 411, and the supporting member 411 may include a battery accommodation portion 412 for receiving the battery 350 (e.g., 350 of FIG. 5). The electronic device 400 may include an adhesive member 450 attached to the battery accommodation portion 412. The description of the adhesive member 450 attached to the battery accommodation portion 412 may be the same as the description of the adhesive member 430 described with reference to FIGS. 1 to 13.

According to an embodiment, the adhesive member 450 may include an adhesive portion 451 and a slit 453. A plurality of slits 453 may be formed to be spaced apart from each other in the length direction of the adhesive member 450. The description of the shape of the slit 453 may be the same as the description of the slit 433 described with reference to FIGS. 1 to 13. For example, the slit 453 may include a first slit portion 4531, a second slit portion 4532, and a third slit portion 4533.

FIG. 15 is a view illustrating a disassembly process of the housing 410 and the display 420. FIG. 15(a) illustrates an example in which the housing 410 and the display 420 are separated using disassembly devices Z1, Z2. FIG. 15(b) illustrates a process of disassembling the housing 410 and the display 420.

According to an embodiment, the housing 410 and the display 420 may be separated from each other using the first and second disassembly devices Z1, Z2. The display 420 may be fixed to the first disassembly device Z1 and may be moved together with the first disassembly device Z1. The housing 410 may be fixed to the second disassembly device Z2. When the first disassembly device Z1 and the second disassembly device Z2 are separated, the display 420 and the film 426 may be moved together with the first disassembly device Z1, and the adhesive member 430 may be fixed to the second disassembly device Z2 together with the housing 410. The display 420 may be moved in the disassembly direction Q by the first disassembly device Z1, and the adhesive member 430 may be separated from the film 426 in the order from the portion adjacent to the second direction L2 to the portion adjacent to the first direction L1.

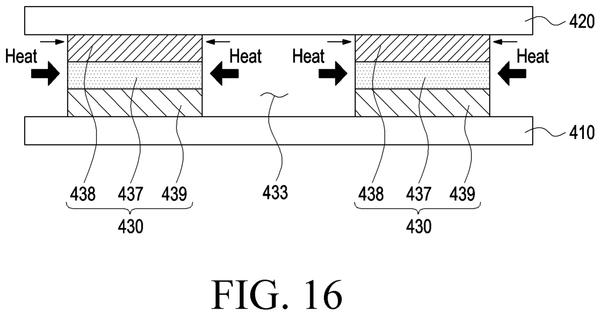

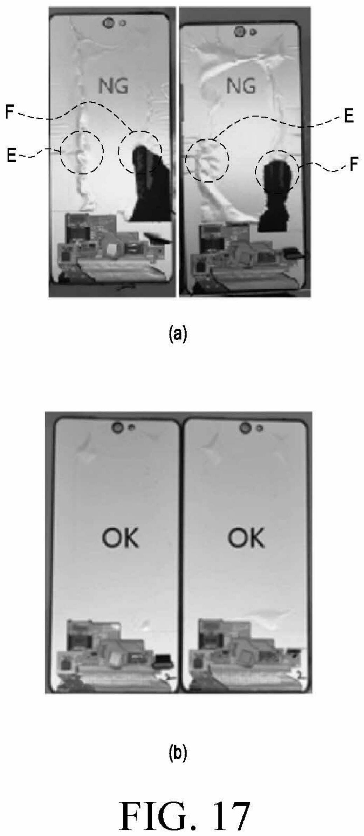

FIG. 16 is a view conceptually describing effects of an adhesive member 430, 530 according to various embodiments of the disclosure. FIG. 17 is a view illustrating comparison between effects of the adhesive member 430, 530 according to various embodiments of the disclosure and a comparative embodiment. The components described with reference to FIGS. 16 and 17 may be identical in whole or part to the components described with reference to FIGS. 1 to 15.

Referring to FIG. 16, the adhesive member 430 may couple the housing 410 to the display 420 and may include a slit 433. The adhesive member 430 may include a base layer 437, a first layer 438 for coupling the base layer 437 and the display 420, and a second layer 439 for coupling the base layer 437 and the housing 410. The adhesive member 430 according to embodiments of the disclosure may be a heat response tape (HR tape) that decreases adhesive force when heat is applied. When separating the housing 410 and the display 420 as illustrated in FIG. 15, the user applies heat to the adhesive member 430 to reduce the adhesive force between the film 426 and the adhesive member 430. For example, since the slit 433 is formed in the adhesive member 430 as in the embodiment of the disclosure, heat spreads evenly to the layers 438 and 439 disposed on two opposite sides of the slit 433, facilitating the separation between the film 426 and the adhesive member 430.

Referring to FIG. 17, FIG. 17a illustrates a state in which a delamination E and a tearing F occur in a film e.g., 426 of FIG. 6 when the housing and the display are separated according to the comparative embodiment. FIG. 17(b) illustrates a state in which no delamination and tearing occurs in the film (e.g., 426 of FIG. 6) when separating the housing and the display according to the embodiment of the disclosure. Referring to FIG. 17, it may be identified that the delamination and tearing of the film (e.g., 426 of FIG. 6) has been decreased or removed by the adhesive member 430 according to the embodiment of the disclosure.

The electronic device includes a display that provides visual information to the user. The display includes a panel that outputs electrical signals as visual elements, and a film (e.g., a Cu film) is attached to remove electromagnetic noise generated from the panel. The film is attached to the housing through the adhesive member such as tape.

However, when the display was separated from the housing, the tape was not properly separated from the film, causing delamination of the surface of the film, and hence making it difficult to recycle the film and dismantle the display.

According to various embodiments of the disclosure, slits are continuously arranged along the direction in which the tape is separated, thereby reducing the delamination of the film at the position in which the slits are absent.

According to various embodiments of the disclosure, heat may be uniformly spread in the width direction of the tape by adjusting the width of the slit along the direction in which the tape is separated.

The disclosure is not limited to the foregoing embodiments but various modifications or changes may rather be made thereto without departing from the spirit and scope of the disclosure.

An electronic device according to various embodiments of the disclosure may reduce delamination of a film by removing a portion of the adhesive member where the slit is not formed by disposing a plurality of slits to at least partially overlap.

The electronic device according to various embodiments of the disclosure may constantly maintain the width of the adhesive member in the length direction due to the shape of the slit including the first to third slit portions.

Effects obtainable from the disclosure are not limited to the above-mentioned effects, and other effects not mentioned may be apparent to one of ordinary skill in the art from the following description.

An electronic device (e.g., 400 of FIG. 6) according to an embodiment of the disclosure comprises a housing (e.g., 410 of FIG. 6) comprising a supporting member (e.g., 411 of FIG. 6) extending in a first direction.

The electronic device (e.g., 400 of FIG. 6) according to an embodiment of the disclosure comprises a display (e.g., 420 of FIG. 6) comprising a film (e.g., 426 of FIG. 6) facing the supporting member (e.g., 411 of FIG. 6).

The electronic device (e.g., 400 of FIG. 6) according to an embodiment of the disclosure comprises an adhesive member (e.g., 430 of FIG. 12A) disposed between the supporting member (e.g., 411 of FIG. 6) and the film (e.g., 426 of FIG. 6), comprising a plurality of slits (e.g., 433 of FIG. 12A) disposed in the first direction, and having a width in a second direction crossing the first direction.

According to an embodiment of the disclosure, at least one of the plurality of slits (e.g., 433 of FIG. 12A) comprises a first slit portion (e.g., 4331 of FIG. 12A) extending along the first direction, and facing, in a width direction of the adhesive member (e.g., 430 of FIG. 12A), a portion of another one adjacent to the first slit portion (e.g., 4331 of FIG. 12A) among the plurality of slits (e.g., 433 of FIG. 12A).

According to an embodiment of the disclosure, at least one of the plurality of slits (e.g., 433 of FIG. 12A) comprises a second slit portion (e.g., 4332 of FIG. 12A) spaced apart from the first slit portion (e.g., 4331 of FIG. 12A), and facing, in a width direction of the adhesive member (e.g., 430 of FIG. 12A), a portion of another one adjacent to the second slit portion (e.g., 4332 of FIG. 12A) among the plurality of slits (e.g., 433 of FIG. 12A).

According to an embodiment of the disclosure, at least one of the plurality of slits (e.g., 433 of FIG. 12A) comprises a third slit portion (e.g., 4333 of FIG. 12A) connecting the first slit portion (e.g., 4331 of FIG. 12A) and the second slit portion (e.g., 4332 of FIG. 12A) and obliquely extending with respect to the first direction.

According to an embodiment of the disclosure, the adhesive member (e.g., 430 of FIG. 12A) may comprise a side adhesive portion (e.g., 430a, 430b of FIG. 12A) extending in the first direction.

According to an embodiment of the disclosure, at all portions of the side adhesive portion (e.g., 430a, 430b of FIG. 12A), at least a portion of the plurality of slits (e.g., 433 of FIG. 12A) may be positioned within a width of the side adhesive portion (e.g., 430a, 430b of FIG. 12A).

According to an embodiment of the disclosure, the plurality of slits (e.g., 433 of FIG. 11) may comprise a first slit (e.g., 433a of FIG. 11).

According to an embodiment of the disclosure, the plurality of slits (e.g., 433 of FIG. 11) may comprise a second slit (e.g., 433b of FIG. 11) arranged in the first direction with the first slit (e.g., 433a of FIG. 11).

According to an embodiment of the disclosure, the first slit portion (e.g., 433a1 of FIG. 12A) of the first slit (e.g., 433a of FIG. 11) and the first slit portion (e.g., 433b1 of FIG. 12A) of the second slit (e.g., 433b of FIG. 11) may be spaced apart from each other in the first direction.

According to an embodiment of the disclosure, a third slit portion (e.g., 433a3 of FIG. 12A) of the first slit (e.g., 433a of FIG. 12A) and a third slit portion (e.g., 433b3 of FIG. 12A) of the second slit (e.g., 433b of FIG. 12A) may be spaced apart from each other in the first direction.

According to an embodiment of the disclosure, the adhesive member (e.g., 430 of FIG. 12A) may comprise a first section (e.g., S1 of FIG. 12A) in which the first slit portion (e.g., 4331 of FIG. 12A) or the second slit portion (e.g., 4332 of FIG. 12A) is positioned in the width direction.

According to an embodiment of the disclosure, the adhesive member (e.g., 430 of FIG. 12A) may comprise a second section (e.g., S2 of FIG. 12A) in which the first slit portion (e.g., 4331 of FIG. 12A) or the second slit portion (e.g., 4332 of FIG. 12A) is positioned in the width direction, and which is spaced from the first section (e.g., S1 of FIG. 12A) in the first direction.

According to an embodiment of the disclosure, the adhesive member (e.g., 430 of FIG. 12A) may comprise a third section (e.g., S3 of FIG. 12A) formed between the first section (e.g., S1 of FIG. 12A) and the second section (e.g., S2 of FIG. 12A), and in which the third slit portion (e.g., 4333 of FIG. 12A) is positioned in the width direction.

According to an embodiment of the disclosure, the adhesive member (e.g., 430 of FIG. 12A) may comprise a first adhesive area (e.g., 4311 of FIG. 12A).

According to an embodiment of the disclosure, the adhesive member (e.g., 430 of FIG. 12A) may comprise a second adhesive area (e.g., 4312 of FIG. 12A) spaced apart from the first adhesive area (e.g., 4311 of FIG. 12A) in the width direction.

According to an embodiment of the disclosure, the adhesive member (e.g., 430 of FIG. 12A) may comprise a third adhesive area (e.g., 4313 of FIG. 12A) formed between the first adhesive area (e.g., 4311 of FIG. 12A) and the second adhesive area (e.g., 4312 of FIG. 12A).

According to an embodiment of the disclosure, the first slit portion (e.g., 4331 of FIG. 12A) of any one of the plurality of slits (e.g., 433 of FIG. 12A) may be formed between the first adhesive area (e.g., 4311 of FIG. 12A) and the third adhesive area (e.g., 4313 of FIG. 12A), and the second slit portion (e.g., 4332 of FIG. 12A) of another one of the plurality of slits (e.g., 433 of FIG. 12A) is formed between the second adhesive area (e.g., 4312 of FIG. 12A) and the third adhesive area (e.g., 4313 of FIG. 12A).

According to an embodiment of the disclosure, the adhesive member (e.g., 430 of FIG. 12A) may comprise a second adhesive area (e.g., 4312 of FIG. 12A) spaced apart from the first adhesive area (e.g., 4311 of FIG. 12A) in the width direction and forming the third slit portion (e.g., 4333 of FIG. 12A) between the first adhesive area (e.g., 4311 of FIG. 12A) and the second adhesive area (e.g., 4312 of FIG. 12A).

According to an embodiment of the disclosure, the third slit portion (e.g., 4333 of FIG. 12A) may comprise a first inclined surface (e.g., 4333a of FIG. 12A) facing the second slit portion (e.g., 4332 of FIG. 12A) of the adjacent slit.

According to an embodiment of the disclosure, the third slit portion (e.g., 4333 of FIG. 12A) may comprise a second inclined surface (e.g., 4333b of FIG. 12A) facing the first slit portion (e.g., 4331 of FIG. 12A) of another adjacent slit.

According to an embodiment of the disclosure, the first slit portion (e.g., 4331 of FIG. 12A) may comprise a first edge (e.g., 4331a of FIG. 12A) extending in an inclined direction of the second inclined surface (e.g., 4333b of FIG. 12A), and the second slit portion (e.g., 4332 of FIG. 12A) comprises a second edge (e.g., 4332a of FIG. 12A) extending in an inclined direction of the first inclined surface (e.g., 4333a of FIG. 12A).

According to an embodiment of the disclosure, a width of the third slit portion (e.g., 4333 of FIG. 12A) may be larger than a width of the first slit portion (e.g., 4331 of FIG. 12A) or the second slit portion (e.g., 4332 of FIG. 12A).

According to an embodiment of the disclosure, a width of the first slit portion (e.g., 4331 of FIG. 12A) and the second slit portion (e.g., 4332 of FIG. 12A) may be in a range of 0.8 mm to 1.2 mm, and a width of the third slit portion (e.g., 4333 of FIG. 12A) may be in a range of 1.8 mm to 2.2 mm.

According to an embodiment of the disclosure, the adhesive member (e.g., 430 of FIG. 12A) may comprise a side adhesive portion (e.g., 430a, 430b of FIG. 8) extending in the first direction.

According to an embodiment of the disclosure, the plurality of slits (e.g., 433 of FIG. 8) may be formed at the side adhesive portion (e.g., 430a, 430b of FIG. 8).

According to an embodiment of the disclosure, when the adhesive member (e.g., 430 of FIG. 6) is separated from the film (e.g., 426 of FIG. 6), the plurality of slits (e.g., 433 of FIG. 12A) may be separated from the film (e.g., 426 of FIG. 6) in an order disposed along the first direction.

The electronic device (e.g., 400 of FIG. 6) according to an embodiment may comprise a release sheet (e.g., 440 of FIG. 7) detachably coupled to the adhesive member (e.g., 430 of FIG. 7).

According to an embodiment of the disclosure, the release sheet (e.g., 440 of FIG. 7) may comprise a slit cover (e.g., 443 of FIG. 9) shaped to correspond to the plurality of slits (e.g., 433 of FIG. 7).

According to an embodiment of the disclosure, the release sheet (e.g., 440 of FIG. 9) may comprise a gripping portion (e.g., 444 of FIG. 9) protruding in a direction toward an outside of the release sheet (e.g., 440 of FIG. 9).

An electronic device (e.g., 400 of FIG. 6) according to an embodiment of the disclosure comprises a housing (e.g., 410 of FIG. 6) comprising a supporting member (e.g., 411 of FIG. 6) extending in a first direction, a display (e.g., 420 of FIG. 6) comprising a film (e.g., 426 of FIG. 6) facing the supporting member (e.g., 411 of FIG. 6), and an adhesive member (e.g., 430, 530 of FIGS. 12A and 13) disposed between the supporting member (e.g., 411 of FIG. 6) and the film (e.g., 426 of FIG. 6), comprising a plurality of slits (e.g., 433, 533 of FIGS. 12A and 13) arranged in the first direction, and having a width in a second direction crossing the first direction. At all portions of the adhesive member (e.g., 430, 530 of FIGS. 12A and 13) extending along the first direction, at least a portion of the plurality of slits (e.g., 433, 533 of FIGS. 12A and 13) is positioned in the width of the adhesive member (e.g., 430, 530 of FIGS. 12A and 13).

According to an embodiment of the disclosure, the adhesive member (e.g., 430, 530 of FIGS. 12A and 13) may comprise an overlapping section (e.g., S1, S2 of FIG. 12A) in which a portion of one of the plurality of slits (e.g., 433, 533 of FIGS. 12A and 13) and a portion of another one of the plurality of slits (e.g., 433, 533 of FIGS. 12A and 13) face each other in the width direction.

According to an embodiment of the disclosure, at least one of the plurality of slits (e.g., 433, 533 of FIGS. 12A and 13) may have a portion inclined along the first direction.

According to an embodiment of the disclosure, when the adhesive member (e.g., 430, 530 of FIGS. 12A and 13) is separated from the film (e.g., 426 of FIG. 6), the plurality of slits (e.g., 433, 533 of FIGS. 12A and 13) may be separated from the film (e.g., 426 of FIG. 6) in an order disposed along the first direction.

The electronic device (e.g., 400 of FIG. 6) according to an embodiment may further comprise a release sheet (e.g., 440 of FIG. 7) detachably coupled to the adhesive member (e.g., 430, 530 of FIG. 13).

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device comprising:
a housing (410) comprising a supporting member (411) extending in a first direction;
a display (420) comprising a film (426) facing the supporting member (411); and
an adhesive member (430) disposed between the supporting member (411) and the film (426), comprising a plurality of slits (433) disposed in the first direction, and having a width in a second direction crossing the first direction, wherein at least one (433b) of the plurality of slits (433) comprises:
a first slit portion (4331; 433b1) extending along the first direction, and facing, in a width direction (W1) of the adhesive member (430), a portion (433a2) of another one (433a) adjacent to the first slit portion (4331; 433b1) among the plurality of slits (433);
a second slit portion (4332; 433b2) spaced apart from the first slit portion (4331; 433b1), and facing, in a width direction (W2) of the adhesive member (430), a portion (433c1) of another one (433c) adjacent to the second slit portion (4332; 433b2) among the plurality of slits (433); and
a third slit portion (4333; 433b3) connecting the first slit portion (4331; 433b1) and the second slit portion (4332; 433b2) and obliquely extending with respect to the first direction.

2. The electronic device of claim 1, wherein the adhesive member (430) comprises a side adhesive portion (430a, 430b) extending in the first direction, and wherein at all portions of the side adhesive portion (430a, 430b), at least a portion of the plurality of slits (433) is positioned within a width of the side adhesive portion (430a, 430b).

3. The electronic device of claim 1 or 2, wherein the plurality of slits (433) comprise:
a first slit (433a); and
a second slit (433b) arranged in the first direction with the first slit (433a),
wherein the first slit portion (433a1) of the first slit (433a) and the first slit portion (433b1) of the second slit (433b) are spaced apart from each other in the first direction.

4. The electronic device of any one of claims 1 to 3, wherein the plurality of slits (433) comprise:
a first slit (433a); and
a second slit (433b) arranged in the first direction with the first slit (433a),
wherein a third slit portion (433a3) of the first slit (433a) and the third slit portion (433b3) of the second slit (433b) are spaced apart from each other in the first direction.

5. The electronic device of any one of claims 1 to 4, wherein the adhesive member (430) comprises:
a first section (S1) in which the first slit portion (4331) or the second slit portion (4332) is positioned in the width direction;
a second section (S2) in which the first slit portion (4331) or the second slit portion (4332) is positioned in the width direction, and which is spaced from the first section (S1) in the first direction; and
a third section (S3) formed between the first section (S1) and the second section (S2), and in which the third slit portion (4333) is positioned in the width direction.

6. The electronic device of any one of claims 1 to 5, wherein the adhesive member (430) comprises:
a first adhesive area (4311);
a second adhesive area (4312) spaced apart from the first adhesive area (4311) in the width direction; and
a third adhesive area (4313) formed between the first adhesive area (4311) and the second adhesive area (4312), and
wherein the first slit portion (4331) of any one of the plurality of slits (433) is formed between the first adhesive area (4311) and the third adhesive area (4313), and the second slit portion (4332) of another one of the plurality of slits (433) is formed between the second adhesive area (4312) and the third adhesive area (4313).

7. The electronic device of any one of claims 1 to 6, wherein the adhesive member (430) comprises:
a first adhesive area (4311); and
a second adhesive area (4312) spaced apart from the first adhesive area (4311) in the width direction and forming the third slit portion (4333) between the first adhesive area (4311) and the second adhesive area (4312).

8. The electronic device of any one of claims 1 to 7, wherein the third slit portion (4333) comprises:
a first inclined surface (4333a) facing the second slit portion (4332) of an adjacent slit; and
a second inclined surface (4333b) facing the first slit portion (4331) of another adjacent slit, and wherein the first slit portion (4331) comprises a first edge (4331a) extending in an inclined direction of the second inclined surface (4333b), and the second slit portion (4332) comprises a second edge (4332a) extending in an inclined direction of the first inclined surface (4333a).

9. The electronic device of any one of claims 1 to 8, wherein a width of the third slit portion (4333) is larger than a width of the first slit portion (4331) or the second slit portion (4332).

10. The electronic device of any one of claims 1 to 9, wherein a width of the first slit portion (4331) and the second slit portion (4332) is in a range of 0.8 mm to 1.2 mm, and a width of the third slit portion (4333) is in a range of 1.8 mm to 2.2 mm.

11. The electronic device of any one of claims 1 to 10, wherein the adhesive member (430) comprises a side adhesive portion (430a, 430b) extending in the first direction, and wherein the plurality of slits (433) are formed at the side adhesive portion (430a, 430b).

12. The electronic device of any one of claims 1 to 11, wherein when the adhesive member (430) is separated from the film (426), the plurality of slits (433) are separated from the film (426) in an order disposed along the first direction.

13. The electronic device of any one of claims 1 to 12, further comprising a release sheet (440) detachably coupled to the adhesive member (430).

14. The electronic device of claim 13, wherein the release sheet (440) comprises a slit cover (443) shaped to correspond to the plurality of slits (433).

15. The electronic device of claim 13 or 14, wherein the release sheet (440) comprises a gripping portion (444) protruding in a direction toward an outside of the release sheet (440).
